# EUROPÄISCHE PATENTSCHRIFT

(11) **EP 2 714 583 B1**
(45) Veröffentlichungstag und Bekanntmachung des Hinweises auf die Patenterteilung: **10.06.2015**
(21) Anmeldenummer: 12715023.3
(22) Anmeldetag: 04.04.2012
(51) Int. Cl.: B81C 3/00, B01L 3/00

(54) **MIKROFLUIDISCHE VORRICHTUNG MIT ELEKTRONISCHEM BAUTEIL UND FEDERELEMENT**
MICROFLUIDIC DEVICE HAVING AN ELECTRONIC COMPONENT AND A SPRING ELEMENT
DISPOSITIF MICROFLUIDIQUE POURVU D'UN COMPOSANT ÉLECTRONIQUE ET D'UN ÉLÉMENT ÉLASTIQUE

(30) Priorität: 30.05.2011 DE 102011076693
(43) Veröffentlichungstag der Anmeldung: 09.04.2014
(73) Patentinhaber: Robert Bosch GmbH, 70442 Stuttgart (DE)
(72) Erfinder: BRETTSCHNEIDER, Thomas, 70806 Kornwestheim (DE); DORRER, Christian, 70193 Stuttgart (DE)
(86) Internationale Anmeldenummer: PCT/EP2012/056118
(87) Internationale Veröffentlichungsnummer: WO 2012/163577

(56) Entgegenhaltungen:
- EP-A1- 2 366 993
- DE-A1-102004 019 357
- US-A- 5 571 410

## Beschreibung

Die Erfindung geht aus von einer mikrofluidischen Vorrichtung nach Gattung des unabhängigen Anspruchs.

Aus der DE 10 2007 046 305 A1 ist bereits eine mikrofluidische Vorrichtung bekannt, die ein Halbleiterbauelement integriert hat.

Ferner ist aus der WO 2007/084392 A2 die Verwendung einer Feder in einem Ventil einer mikrofluidischen Vorrichtung bekannt.

Aus der DE 10 2004 019 357 A1 ist ein Biosensorchip bekannt, der ein Substrat mit einem Halbleiterchip umfasst, wobei auf dem Halbleiterchip mindestens ein Sensorfeld angeordnet ist.

### Offenbarung der Erfindung

### Vorteile der Erfindung

Die mikrofluidische Vorrichtung mit einem elektronischen Bauteil und einem Federelement zur Befestigung des elektronischen Bauteils in oder an der mikrofluidischen Vorrichtung durch eine Federkraft des Federelements hat dem gegenüber den Vorteil, dass der mechanische Stress auf das elektronische Bauteil kontrollierbar ist. Somit wird eine definierte und dauerhafte Kraftausübung auf das elektronische Bauteil ohne zusätzliche externe Haltesysteme erreicht. Die erfindungsgemäße Vorrichtung ermöglicht ferner, dass Toleranz- und Ausrichtungsprobleme bei der Integration des elektronischen Bauteils in die mikrofluidische Vorrichtung kompensiert werden.

Durch die in den abhängigen Ansprüchen aufgeführten Maßnahmen sind vorteilhafte Weiterbildungen und Verbesserungen der im unabhängigen Anspruch angegebenen Vorrichtung möglich.

Besonders vorteilhaft ist, wenn das elektronische Bauteil einen sensorisch aktiven Bereich aufweist, der einen Kanal in der mikrofluidischen Vorrichtung fluidisch kontaktiert. Denn durch das Federelement zur Befestigung des elektronischen Bauteils wird eine fluidische Abdichtung dadurch erzeugt, dass das elektronische Bauteil mit dem sensorisch aktiven Bereich auf den Kanal angedrückt wird. Der Einsatz von Klebstoffen kann somit vermieden werden. Der sensorisch aktive Bereich des elektronischen Bauteils ermöglicht, Messungen in dem Kanal oder von Inhalten in dem Kanal vorzunehmen. Solche Messungen sind beispielsweise für mikrofluidische Vorrichtungen wie Lab-on-a-Chip-Systeme nützlich.

Erfindungsgemäß weist die mikrofluidische Vorrichtung eine erste Schicht und eine zweite Schicht auf. Dabei ist die erste Schicht über der zweiten Schicht angeordnet. Die zweite Schicht weist einen Einlass für einen Kanal auf. Die erste Schicht weist eine Aussparung mit einer Öffnung zum Kanal auf. Dabei ist das elektronische Bauteil in der Aussparung angeordnet. Das Federelement ist aus der ersten Schicht strukturiert. Mittels des Schichtaufbaus wird eine intrinsische und dauerhafte Klemmung des elektronischen Bauteils erzielt. Es werden hierdurch Herstellungstoleranzen in der Höhe des elektronischen Bauteils und in der Höhe der Aussparung ausgeglichen. Somit wird auch eine korrekte Justage bezüglich der Höhe des elektronischen Bauteils sichergestellt, welches in die Aussparung eingelegt ist. Außerdem bleibt durch die Verwendung des Federelements der mechanische Stress auf das elektronische Bauteil auch bei unterschiedlich starken thermischen Ausdehnungen der Schichten und des elektronischen Bauteils kontrollierbar. Ferner ist die Rückseite des elektronischen Bauteils automatisch gegen Berührung geschützt.

Weiterhin ist es vorteilhaft, wenn das Federelement derart aus der ersten Schicht strukturiert ist, dass das Federelement auf einer der zweiten Schicht abgewandten Oberfläche gegenüber einer das Federelement umgebenden Oberfläche der ersten Schicht nach innen versetzt ist. Dadurch wird bei einer Auslenkung des Federelements ein Überstand über der das Federelement umgebenden Oberfläche der ersten Schicht vermieden. Ein Hinzufügen weiterer Schichten auf die erste Schicht wird somit erleichtert.

Weiterhin ist es zweckmäßig, wenn eine elastische Membran zwischen der ersten Schicht und der zweiten Schicht angeordnet ist. Durch die Membran wird ein Abdichten zwischen dem elektronischen Bauteil und dem Kanal außerhalb des sensorisch aktiven Bereichs des elektronischen Bauteils verbessert. Ebenso ist es vorteilhaft, wenn die elastische Membran und das elektronische Bauelement über eine Schweißnaht entlang des Außenbegrenzung des Kanals verbunden sind. Ein Abdichten des Kanals wird dadurch verbessert.

Ein spiralförmig oder mäanderförmig ausgebildetes Federelement hat den Vorteil, dass sich so besonders kleine Kräfte übertragen lassen.

Ferner ist es vorteilhaft, wenn der Kanal keinen Kontakt zu einem Übergang zwischen der ersten Schicht und dem elektronischen Bauteil aufweist, denn damit wird eine gute Dichtigkeit erreicht.

### Kurze Beschreibung der Zeichnungen

Ausführungsbeispiele der Erfindung sind in den Zeichnungen dargestellt und in der nachfolgenden Beschreibung näher erläutert.

### Es zeigen

Figur 1 eine Draufsicht auf eine erste Ausführungsform der erfindungsgemäßen mikrofluidischen Vorrichtung,
Figur 2 einen Querschnitt entlang der Linie A - A' durch die in Figur 1 gezeigte erste Ausführungsform einer erfindungsgemäßen mikrofluidischen Vorrichtung,
Figur 3 einen Querschnitt durch eine zweite Ausführungsform einer erfindungsgemäßen mikrofluidischen Vorrichtung,
Figur 4 einen Querschnitt durch eine dritte Ausführungsform einer erfindungsgemäßen mikrofluidischen Vorrichtung,
Figur 5 eine Aufsicht auf eine vierte Ausführungsform einer erfindungsgemäßen Vorrichtung,
Figur 6 einen Querschnitt durch eine fünfte Ausführungsform einer erfindungsgemäßen mikrofluidischen Vorrichtung,
Figur7 eine Aufsicht auf eine sechste Ausführungsform der mikrofluidischen Vorrichtung,
Figur 8 eine Aufsicht auf eine siebte Ausführungsform einer erfindungsgemäßen mikrofluidischen Vorrichtung,
Figur 9 eine Aufsicht auf eine achte Ausführungsform einer erfindungsgemäßen mikrofluidischen Vorrichtung,
   und
Figur 10 einen Querschnitt entlang der Linie B-B' durch die in Figur 9 gezeigte achte Ausführungsform einer erfindungsgemäßen mikrofluidischen Vorrichtung.

### Ausführungsformen der Erfindung

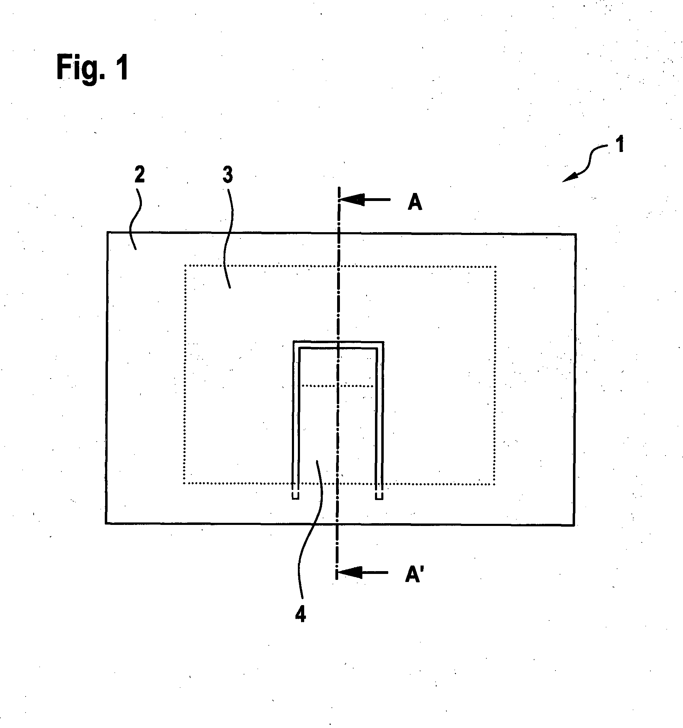

Figur 1 zeigt eine schematische Aufsicht auf eine erste Ausführungsform 1 einer erfindungsgemäßen mikrofluidischen Vorrichtung. Die erste Ausführungsform 1 einer mikrofluidischen Vorrichtung weist ein elektronisches Bauteil 3 auf. Das elektronische Bauteil 3 ist in einer Aussparung einer ersten Schicht 2 angeordnet. Ein Federelement 4 ist aus der ersten Schicht 2 strukturiert.

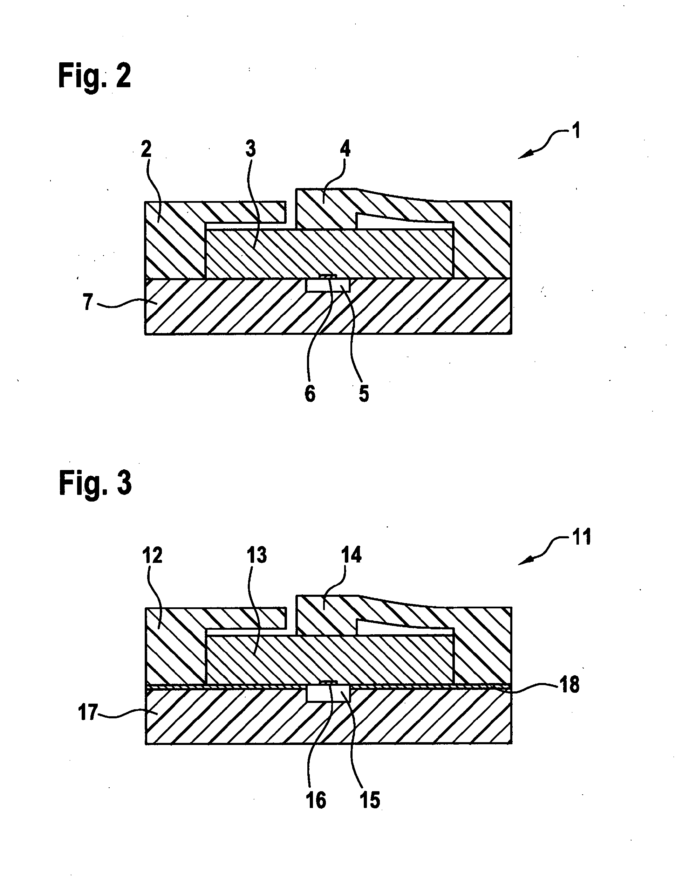

Figur 2 zeigt einen schematischen Querschnitt durch die erste Ausführungsform 1 entlang der Linie A-A', wie sie in Figur 1 angedeutet ist. Die Figur 2 verdeutlicht somit einen schichtweisen Aufbau der mikrofluidischen Vorrichtung 1. Die erste Schicht 2 ist über einer zweiten Schicht 7 angeordnet. Die erste Schicht 2 weist eine Aussparung für das elektronische Bauteil 3 auf. Die erste Schicht 2 ist so strukturiert, dass das Federelement 4 auf der Seite strukturiert ist, welche der zweiten Schicht 7 abgewandt ist. Durch das Federelement 4 wirkt somit eine Federkraft auf das elektronische Bauteil 3 in Richtung der zweiten Schicht 7. Die zweite Schicht 7 weist einen Einlass für einen Kanal 5 auf. Der Kanal 5 ist auf der der ersten Schicht 2 zugewandten Oberfläche offen. Ebenso ist die Aussparung der ersten Schicht 2 auf der zur zweiten Schicht 7 zugewandten Oberfläche offen, so dass das elektronische Bauteil 3, welches in der Aussparung der ersten Schicht 2 angeordnet ist, den Kanal 5 abdeckt. Auf diese Weise kontaktiert ein sensorisch aktiver Bereich 6 des elektronischen Bauteils 3 den Kanal 5 fluidisch.

Das elektronische Bauteil 3 ist beispielsweise ein Halbleiterbauelement, das einen mikrofluidischen Sensor als sensorisch aktiven Bereich 6 aufweist, zum Beispiel einen Flusssensor oder einen Drucksensor. Ebenso sind beispielsweise als elektronisches Bauteil 3 auch integrierte Schaltungen mit einem Mikrochip und einem oder mehreren Sensoren im sensorisch aktiven Bereich 6 denkbar, beispielsweise mit elektrochemischer oder kapazitiver Auslesung.

Die Schichten 2, 7 können beispielsweise aus Polymermaterial mit einer gewissen Elastizität, z.B. PC, COP, COC, PMMA, bestehen.

Die erste Ausführungsform 1 einer erfindungsgemäßen mikrofluidischen Vorrichtung kann beispielsweise in einer Aufsicht gemäß Figur 1 Abmessungen von ca. 10 mm x 10 mm aufweisen, oder beispielsweise eine typische Abmessung eines Objektträgers von 75 mm x 25 mm. Das elektronische Bauteil 3 in einer Aufsicht gemäß Figur 1 hat als Ausmaße beispielsweise einen Bereich von 2 mm x 2 mm bis 20 mm x 20 mm. Die Schichten 2, 7 haben beispielsweise eine Höhe von 0,2 bis 2 mm. Das elektronische Bauteil 3 hat eine Höhe von beispielsweise 0,1 bis 1,5 mm. Die Höhen verlaufen vertikal in dem Querschnitt gemäß Figur 2.

Das Federelement 4 hat beispielsweise eine Breite von 0,5 bis 5 mm, wobei die Breite eine Ausdehnung in der in Figur 1 senkrecht zu der Linie A-A' räumlichen Dimension ist. Das Federelement hat einen Federarm, der beispielsweise eine Länge von 5 bis 12 mm aufweist. Die Länge ist eine Ausdehnung in der Figur 1 parallel zu der Linie A-A'. Der Federarm kann beispielsweise um 0,1 bis 0,5 mm ausgelenkt werden. Dadurch lassen sich beispielsweise Kräfte von 0,1 N bis 2 N pro Federelement umsetzen.

Eine erfindungsgemäße mikrofluidische Vorrichtung wird beispielsweise durch ein Aufsetzen der einzelnen Elemente, also der Schichten 1, 2 und des elektronischen Bauteils 3, und durch ein Fügen beispielsweise mittels Kleben oder Laserdurchstrahlschweißen hergestellt. Bei der Herstellung wird das Federelement 4 durch das elektronische Bauteil 3 ausgelenkt, so dass nach der Herstellung eine Federkraft des Federelements 4 auf das elektronische Bauteil 3 wirkt.

Ferner kann eine elektrische Kontaktierung des elektronischen Bauteils 3 beispielsweise durch eine oder mehrere in eine der Schichten 1, 2 eingelassene Leiterbahnen oder durch zusätzliche Verbindungen in Aussparungen oder in Löchern in den Schichten erreicht werden.

Figur 3 zeigt einen Querschnitt durch eine zweite Ausführungsform 11 der erfindungsgemäßen Vorrichtung. Der Aufbau der zweiten Ausführungsform 11 entspricht größtenteils dem Aufbau der ersten Ausführungsform 1. So weist die zweite Ausführungsform 11 der mikrofluidischen Vorrichtung eine erste Schicht 12, eine zweite Schicht 17, ein elektronisches Bauteil 13, ein Federelement 14, einen Kanal 15 und einen sensorisch aktiven Bereich 16 auf. Die Anordnung, Größenverhältnisse und Materialien der Elemente entsprechen denen der ersten Ausführungsform 1. Allerdings weist die zweite Ausführungsform 11 im Unterschied zur ersten Ausführungsform 1 eine elastische Membran 18 auf. Die elastische Membran 18 ist zwischen der zweiten Schicht 17 und der ersten Schicht 12 bzw. dem elektronischen Bauteil 13 angeordnet. Die elastische Membran 18 ist im Bereich des Kanals 15 geöffnet, so dass der sensorisch aktive Bereich 16 mit dem Kanal 15 weiterhin im Kontakt ist. Die elastische Membran 18 besteht beispielsweise aus einem thermoplastischen Elastomer. Durch die elastische Membran 18 wird ein Abdichten des Kanals verbessert.

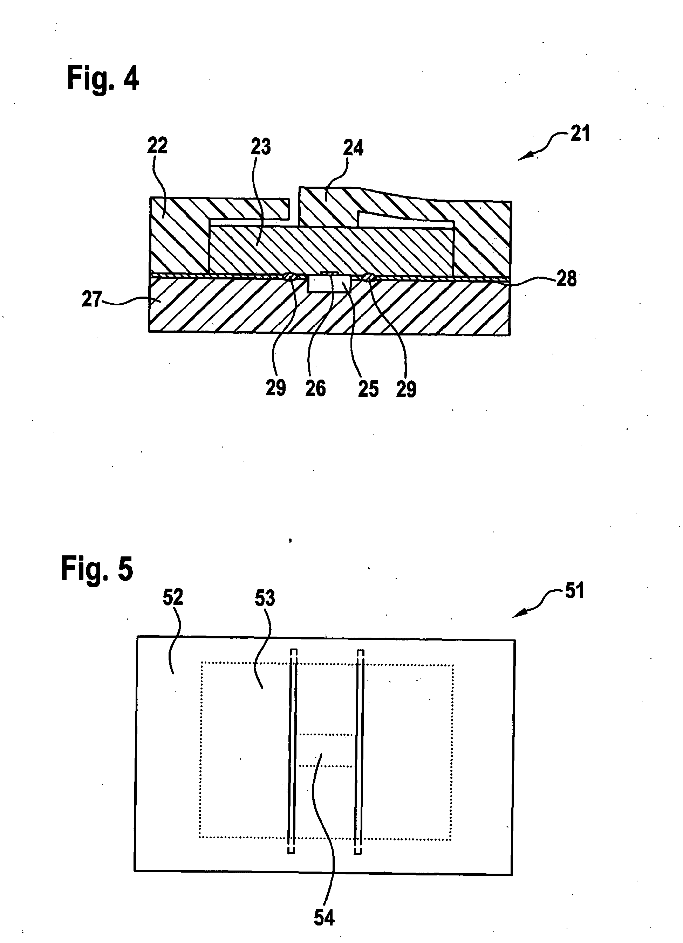

Figur 4 zeigt einen Querschnitt durch eine dritte Ausführungsform 21 der mikrofluidischen Vorrichtung. Entsprechend den ersten beiden Ausführungsformen weist auch die dritte Ausführungsform 21 eine erste Schicht 22, eine zweite Schicht 27, ein elektronisches Bauteil 23, ein Federelement 24, einen Kanal 25, einen sensorisch aktiven Bereich 26 und eine elastische Membran 28 auf. Die Anordnung dieser Elemente ist entsprechend der zweiten Ausführungsform 11 der mikrofluidischen Vorrichtung. Weiter weist die dritte Ausführungsform 21 eine Schweißnaht 29 auf, die entlang des Kanals 25 verläuft. Die Schweißnaht 29 verbindet die Membran 28 mit den Schichten 22, 27 und dem elektronischen Bauteil 23. Auch hierdurch wird die fluidische Dichtheit der mikrofluidischen Vorrichtung gemäß der Ausführungsform 21 verbessert. Optional kann die fluidische Dichtheit durch eine flächige Verschweißung der elastischen Membran 28 mit den Schichten 22, 27 und dem elektronischen Bauteil 23 weiterhin verbessert werden.

Figur 5 zeigt eine Darstellung einer vierten Ausführungsform 51 einer erfindungsgemäßen mikrofluidischen Vorrichtung in Aufsicht. Die vierte Ausführungsform 51 der mikrofluidischen Vorrichtung weist wieder eine erste Schicht 52, ein in eine Aussparung der ersten Schicht 52 eingelassenes elektronisches Bauteil 53 und ein Federelement 54 auf. Das Federelement 54 weist zwei Federarme auf. Das Federelement 54 mit den zwei Federarmen hat beispielsweise eine Breite von 1 bis 5 mm, eine Länge von 5 bis 15 mm und eine Dicke von 0,1 bis 0,8 mm. Die Länge des Federarms bemisst sich entlang der Seitenbegrenzung des Federelements, welche durch breite Strichstärke in Figur 5 dargestellt sind. Die Breite bemisst sich aus dem Abstand zwischen diesen beiden Seitenbegrenzungen.

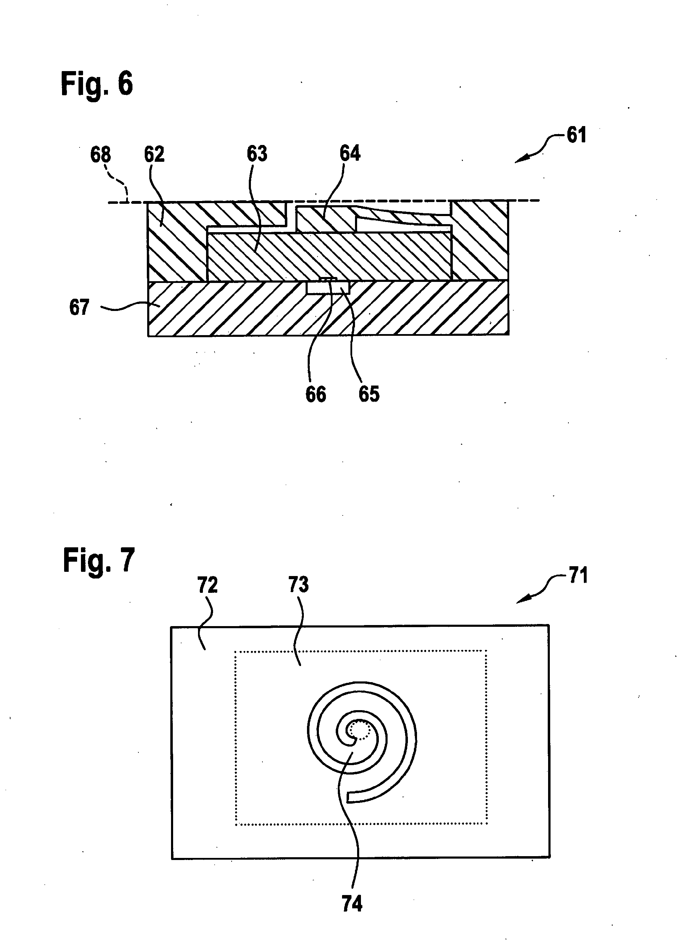

Figur 6 zeigt einen Querschnitt durch eine fünfte Ausführungsform 61 einer erfindungsgemäßen mikrofluidischen Vorrichtung. Entsprechend der ersten Ausführungsform weist auch die fünfte Ausführungsform 61 eine erste Schicht 62, eine zweite Schicht 67, ein elektronisches Bauteil 63, welches in einer Aussparung der ersten Schicht 62 angeordnet ist, ein Federelement 64, einen Kanal 65, welcher als Aussparung in der zweiten Schicht 67 eingelassen ist und einen sensorisch aktiven Bereich 66 des elektronischen Bauteils 63 auf. Die fünfte Ausführungsform 61 einer mikrofluidischen Vorrichtung unterscheidet sich von der ersten Ausführungsform einer mikrofluidischen Vorrichtung, dadurch, dass die erste Schicht 62 derart strukturiert ist, dass das Federelement 64 bei einer Auslenkung nicht über die der zweiten Schicht 67 abgewandten Oberfläche hinausragt. Die gestrichelte Linie 68 in Figur 6 verdeutlicht die Oberfläche, die das Federelement umgibt. Der Abstand zwischen dem Federelement 64 und der gestrichelten Linie 68 wird auch bei einer starken Auslenkung des Federelements 64 nicht durch das Federelement 64 überragt. Dieser Versatz des Federelements 64 in der ersten Schicht 62 nach innen ermöglicht, dass auch weitere Schichten auf die erste Schicht 62 aufgesetzt werden könnten.

Eine sechste Ausführungsform 71 einer erfindungsgemäßen mikrofluidischen Vorrichtung zeigt Figur 7 in einer Aufsicht. Ebenfalls wird hier gezeigt, dass die sechste Ausführungsform 71 eine erste Schicht 72, ein in diese Schicht integriertes elektronisches Bauteil 73 und ein Federelement 74 aufweist. Das Federelement 74 weist eine spiralförmige Form auf, das heißt, das Federelement 64 hat dadurch einen Federarm, der durch seine Länge besonders kleine Kräfte übertragen kann.

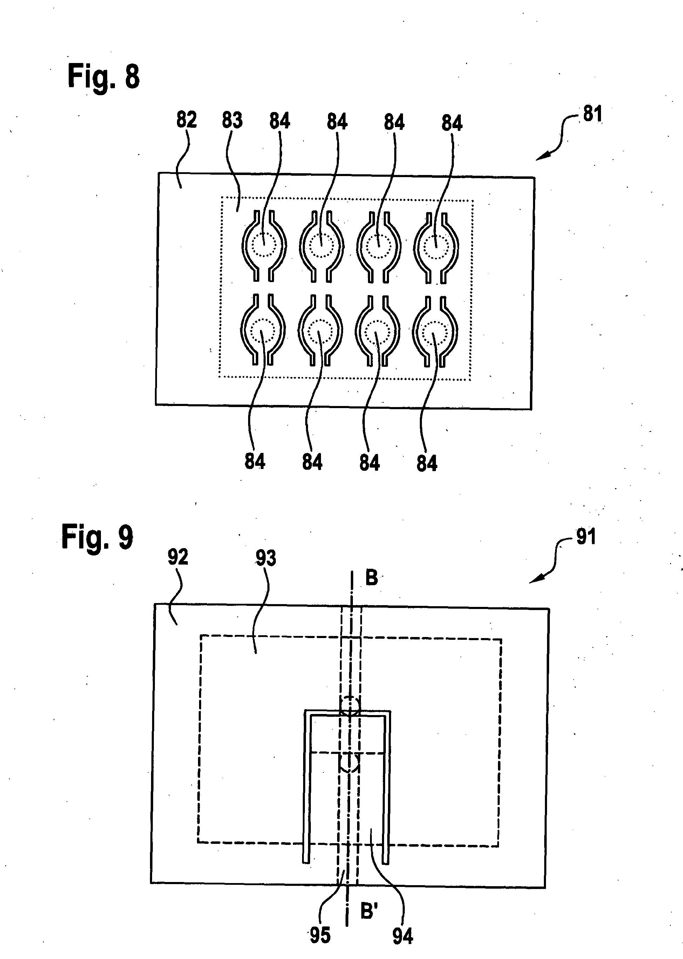

Eine siebte Ausführungsform 81 einer erfindungsgemäßen mikrofluidischen Vorrichtung ist in Aufsicht in Figur 8 gezeigt. Die siebte Ausführungsform 81 weist wiederum eine erste Schicht 82 und ein elektronisches Bauteil 83 auf. Ferner weist die siebte Ausführungsform 81 acht Federelemente 84 auf. Diese Federelemente sind beispielsweise ähnlich zu den Federelementen der vorherigen Ausführungsformen gestaltet, aber weisen eine geringere Größe auf, beispielsweise ein Achtel der Dimensionen des Federelements 74 der sechsten Ausführungsform 71. Durch die mehreren Federelemente 84 wird eine gleichmäßige Kraftverteilung an verschiedenen Stellen des elektronischen Bauteils 83 umgesetzt.

In weiteren Ausführungsformen kann ein Federelement durch eine Änderung der Dicke, Länge oder Breite des Federarms derart angepasst werden, dass sich die Federkraft je nach gewünschtem Zweck gleichmäßig oder auch ungleichmäßig auf ein elektronisches Bauteil verteilt. Ebenso sind Ausführungsbeispiele mit mehreren Federelementen denkbar.

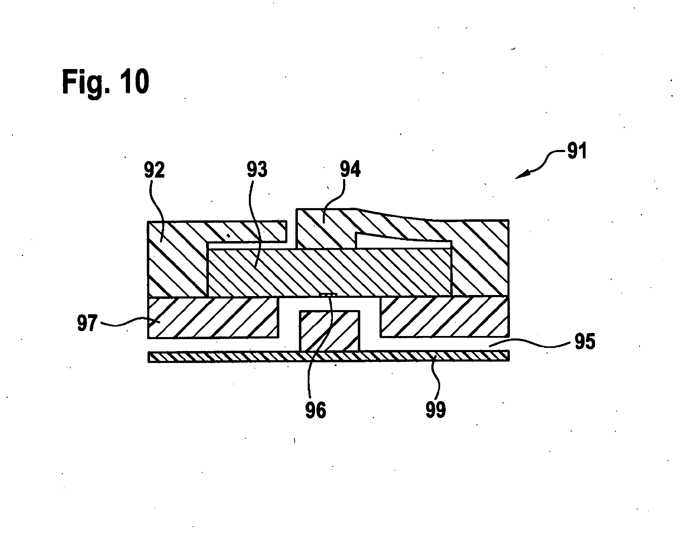

Eine achte Ausführungsform 91 einer erfindungsgemäßen mikrofluidischen Vorrichtung ist in Aufsicht in der Figur 9 und im Querschnitt entlang der Linie B-B' in Figur 10 gezeigt. Die achte Ausführungsform weist eine erste Schicht 92, ein elektronisches Bauteil 93 mit einem sensorische aktiven Bereich 96, ein Federelement 94, einen Kanal 95 und eine zweite Schicht 97 auf. Die achte Ausführungsform 91 unterscheidet sich von den weiteren Ausführungsformen durch die Anordnung des Kanals 95 und einer dritten Schicht 99. Der Kanal 95 verläuft entlang der Linie B-B' gemäß Figur 9. Der Kanal 95 verläuft in der zweiten Schicht 97 unter dem elektronischen Bauteil 93. Der Verlauf des Kanals 95 ist derart ausgelegt, dass der Kanal 95 nur eine Kontaktierung mit dem elektronischen Bauteil 93 und nicht mit der ersten Schicht 92 aufweist. Der Kanal 95 verläuft also derart, dass ein Kontakt des Kanals 95 mit einem Übergang zwischen der ersten Schicht 92 und dem elektronischen Bauteil 93 oder einem Übergang zwischen der ersten Schicht 92 und der Aussparung, in welcher das elektronische Bauteil 93 angeordnet ist, verhindert wird. Der Bereich der Kontaktierung des Kanals 95 mit dem elektronischen Bauteil 93 umfasst den Bereich des sensorisch aktiven Bereichs 96. Die dritte Schicht 99 deckt den Kanal 95 auf der dem elektronischen Bauteil 93 abgewandten Seite ab. Die dritte Schicht 99 ist beispielsweise aus einer Klebefolie, einem Polymer oder einer Polymerschicht hergestellt.

## Patentansprüche

1. Mikrofluidische Vorrichtung (1, 11, 21, 51, 61, 71, 81, 91) mit einem elektronischen Bauteil (3, 13, 23, 53, 63, 73, 83, 93) und einem Federelement (4, 14, 24, 54, 64, 74, 84, 94) zur Befestigung des elektronischen Bauteils (3, 13, 23, 53, 63, 73, 83, 93) in oder an der mikrofluidischen Vorrichtung (1, 11, 21, 51, 61, 71, 81, 91) durch eine Federkraft des Federelements (4, 14, 24, 54, 64, 74, 84, 94), **dadurch gekennzeichnet, dass** die mikrofluidische Vorrichtung (1, 11, 21, 51, 61, 71, 81, 91) eine erste Schicht (2, 12, 22, 52, 62, 72, 82, 93) und eine zweite Schicht (7, 17, 27, 67, 97) aufweist, dass die erste Schicht (2, 12, 22, 52, 62, 72, 82, 92) über der zweiten Schicht (7, 17, 27, 67, 97) angeordnet ist, dass die zweite Schicht (7, 17, 27, 67, 97) einen Einlass für einen Kanal (5, 15, 25, 65, 95) aufweist, dass die erste Schicht (2, 12, 22, 52, 62, 72, 82, 92) eine Aussparung mit einer Öffnung zum Kanal (5,15, 25, 65, 95) aufweist, wobei das elektronische Bauteil (3, 13, 23, 53, 63, 73, 83, 93) in der Aussparung angeordnet ist, und dass das Federelement (4, 14, 24, 54, 64, 74, 84, 94) aus der ersten Schicht (2, 12, 22, 52, 62, 72, 82, 92) strukturiert ist.

2. Mikrofluidische Vorrichtung (1, 11, 21, 51, 61, 71, 81, 91) nach Anspruch 1, **dadurch gekennzeichnet, dass** ein sensorisch aktiver Bereich (6, 16, 26, 66, 96) des elektronischen Bauteils (3, 13, 23, 53, 63, 73, 83, 93) denKanal (5,15, 25, 65, 95) in der mikrofluidischen Vorrichtung (1, 11, 21, 51, 61, 71, 81, 91) fluidisch kontaktiert.

3. Mikrofluidische Vorrichtung (61) nach Anspruch 1 oder 2, **dadurch gekennzeichnet, dass** das Federelement (64) derart aus der ersten Schicht (62) strukturiert ist, dass das Federelement (64) auf einer der zweiten Schicht (67) abgewandten Oberfläche gegenüber einer das Federelement (64) umgebenen Oberfläche der ersten Schicht (62) nach innen versetzt ist.

4. Mikrofluidische Vorrichtung (11, 21) nach einem der Ansprüche 1 bis 3, **dadurch gekennzeichnet, dass** eine elastische Membran (18, 28) zwischen der ersten Schicht (12, 22) und der zweiten Schicht (17, 27) angeordnet ist.

5. Mikrofluidische Vorrichtung (21) nach Anspruch 4, **dadurch gekennzeichnet, dass** die elastische Membran (28) und das elektronische Bauelement (23) über eine Schweißnaht (29) entlang von Außenbegrenzungen des Kanals verbunden sind.

6. Mikrofluidische Vorrichtung (71) nach einem der Ansprüche 1 bis5, **dadurch gekennzeichnet, dass** das Federelement (74) spiralförmig oder mäanderförmig ausgebildet ist.

7. Mikrofluidische Vorrichtung (91) nach einem der Ansprüche 1 bis 6, **dadurch gekennzeichnet, dass** der Kanal (95) derart angeordnet ist, dass ein Kontakt des Kanals (95) mit einem Übergang zwischen der ersten Schicht (92) und dem elektronischen Bauteil (93) oder einem Übergang zwischen der ersten Schicht (92) und der Aussparung, in der das elektronische Bauteil (93) angeordnet ist, verhindert wird.

## Claims

1. Microfluidic device (1, 11, 21, 51, 61, 71, 81, 91) having an electronic component (3, 13, 23, 53, 63, 73, 83, 93) and a spring element (4, 14, 24, 54, 64, 74, 84, 94) for securing the electronic component (3, 13, 23, 53, 63, 73, 83, 93) in or to the microfluidic device (1, 11, 21, 51, 61, 71, 81, 91) by way of a spring force of the spring element (4, 14, 24, 54, 64, 74, 84, 94), **characterized in that** the microfluidic device (1, 11, 21, 51, 61, 71, 81, 91) has a first layer (2, 12, 22, 52, 62, 72, 82, 92) and a second layer (7, 17, 27, 67, 97), **in that** the first layer (2, 12, 22, 52, 62, 72, 82, 92) is arranged over the second layer (7, 17, 27, 67, 97), **in that** the second layer (7, 17, 27, 67, 97) has an inlet for a channel (5, 15, 25, 65, 95), **in that** the first layer (2, 12, 22, 52, 62, 72, 82, 92) has a clearance with an opening to the channel (5, 15, 25, 65, 95), the electronic component (3, 13, 23, 53, 63, 73, 83, 93) being arranged in the clearance, and **in that** the spring element (4, 14, 24, 54, 64, 74, 84, 94) is structured from the first layer (2, 12, 22, 52, 62, 72, 82, 92).

2. Microfluidic device (1, 11, 21, 51, 61, 71, 81, 91) according to Claim 1, **characterized in that** a sensorily active region (6, 16, 26, 66, 96) of the electronic component (3, 13, 23, 53, 63, 73, 83, 93) fluidically contacts the channel (5, 15, 25, 65, 95) in the microfluidic device (1, 11, 21, 51, 61, 71, 81, 91).

3. Microfluidic device (61) according to Claim 1 or 2, **characterized in that** the spring element (64) is structured from the first layer (62) in such a way that, on a surface facing away from the second layer (62), the spring element (64) is offset inwardly from a surface of the first layer (62) surrounding the spring element (64).

4. Microfluidic device (11, 21) according to one of Claims 1 to 3, **characterized in that** an elastic membrane (18, 28) is arranged between the first layer (12, 22) and the second layer (17, 27).

5. Microfluidic device (21) according to Claim 4, **characterized in that** the elastic membrane (28) and the electronic component (23) are connected by way of a weld seam (29) along outer delimitations of the channel.

6. Microfluidic device (71) according to one of Claims 1 to 5, **characterized in that** the spring element (74) is formed in a spiralling or meandering manner.

7. Microfluidic device (91) according to one of Claims 1 to 6, **characterized in that** the channel (95) is arranged in such a way that contact of the channel (95) with a transition between the first layer (92) and the electronic component (93) or a transition between the first layer (92) and the clearance in which the electronic component (93) is arranged is prevented.

## Revendications

1. Dispositif microfluidique (1, 11, 21, 51, 61, 71, 81, 91) comprenant un composant électronique (3, 13, 23, 53, 63, 73, 83, 93) et un élément de ressort (4, 14, 24, 54, 64, 74, 84, 94) pour la fixation du composant électronique (3, 13, 23, 53, 63, 73, 83, 93) dans ou sur le dispositif microfluidique (1, 11, 21, 51, 61, 71, 81, 91) par une force de ressort de l'élément de ressort (4, 14, 24, 54, 64, 74, 84, 94), **caractérisé en ce que** le dispositif microfluidique (1, 11, 21, 51, 61, 71, 81, 91) présente une première couche (2, 12, 22, 52, 62, 72, 82, 92) et un deuxième couche (7, 17, 27, 67, 97), **en ce que** la première couche (2, 12, 22, 52, 62, 72, 82, 92) est disposée sur la deuxième couche (7, 17, 27, 67, 97), **en ce que** la deuxième couche (7, 17, 27, 67, 97) présente une entrée pour un canal (5, 15, 25, 65, 95), **en ce que** la première couche (2, 12, 22, 52, 62, 72, 82, 92) présente un évidement avec une ouverture vers le canal (5, 15, 25, 65, 95), le composant électronique (3, 13, 23, 53, 63, 73, 83, 93) étant disposé dans l'évidement, et **en ce que** l'élément de ressort (4, 14, 24, 54, 64, 74, 84, 94) est structuré à partir de la première couche (2, 12, 22, 52, 62, 72, 82, 92).

2. Dispositif microfluidique (1, 11, 21, 51, 61, 71, 81, 91) selon la revendication 1, **caractérisé en ce qu'**une région active du point de vue sensoriel (6, 16, 26, 66, 96) du composant électronique (3, 13, 23, 53, 63, 73, 83, 93) vient en contact fluidique avec le canal (5, 15, 25, 65, 95) dans le dispositif microfluidique (1, 11, 21, 51, 61, 71, 81, 91).

3. Dispositif microfluidique (61) selon la revendication 1 ou 2, **caractérisé en ce que** l'élément de ressort (64) est structuré à partir de la première couche (62) de telle sorte que l'élément de ressort (64) soit décalé vers l'intérieur sur une surface opposée à la deuxième couche (67) par rapport à une surface de la première couche (62) entourant l'élément de ressort (64).

4. Dispositif microfluidique (11, 21) selon l'une quelconque des revendications 1 à 3, **caractérisé en ce qu'**une membrane élastique (18, 28) est disposée entre la première couche (12, 22) et la deuxième couche (17, 27).

5. Dispositif microfluidique (21) selon la revendication 4, **caractérisé en ce que** la membrane élastique (28) et le composant électronique (23) sont connectés par le biais d'un joint de soudure (29) le long de limitations extérieures du canal.

6. Dispositif microfluidique (71) selon l'une quelconque des revendications 1 à 5, **caractérisé en ce que** l'élément de ressort (74) est réalisé en forme de spirale ou de méandres.

7. Dispositif microfluidique (91) selon l'une quelconque des revendications 1 à 6, **caractérisé en ce que** le canal (95) est disposé de telle sorte qu'un contact du canal (95) avec une transition entre la première couche (92) et le composant électronique (93) ou une transition entre la première couche (92) et l'évidement dans lequel est disposé le composant électronique (93) soit empêché.
